# EUROPÄISCHE PATENTSCHRIFT

(11) **EP 2 786 422 B1**
(45) Veröffentlichungstag und Bekanntmachung des Hinweises auf die Patenterteilung: **07.08.2019**
(21) Anmeldenummer: 12798211.4
(22) Anmeldetag: 21.11.2012
(51) Int. Cl.: H02S 20/00, H01L 31/046, H01L 31/0465

(54) **RAHMENLOSES SOLARMODUL MIT MODULTRÄGER**
FRAMELESS SOLAR MODULE HAVING A MODULE CARRIER
MODULE SOLAIRE SANS CADRE MUNI D'UN SUPPORT DE MODULE

(30) Priorität: 30.11.2011 EP 11191448
(43) Veröffentlichungstag der Anmeldung: 08.10.2014
(73) Patentinhaber: (CNBM) Bengbu Design & Research Institute for Glass Industry Co., Ltd., Bengbu (CN)
(72) Erfinder: GASS, Robert, 52134 Herzogenrath (DE); KLEYER, Dieter, 52146 Würselen (DE)
(74) Vertreter: Gebauer, Dieter Edmund
(86) Internationale Anmeldenummer: PCT/EP2012/073203
(87) Internationale Veröffentlichungsnummer: WO 2013/079375

(56) Entgegenhaltungen:
- DE-A1- 19 921 044
- DE-A1-102009 057 937
- DE-U1-202010 003 295

## Beschreibung

Photovoltaische Schichtensysteme zur direkten Umwandlung von Sonnenlicht in elektrische Energie sind hinlänglich bekannt. Gemeinhin werden diese als "Solarzellen" bezeichnet, wobei sich der Begriff "Dünnschichtsolarzellen" auf Schichtensysteme mit Dicken von nur wenigen Mikrometern bezieht, die (Träger-)Substrate für eine ausreichende mechanische Festigkeit benötigen. Bekannte Substrate umfassen anorganisches Glas, Kunststoffe (Polymere) oder Metalle, insbesondere Metalllegierungen, und können in Abhängigkeit von der jeweiligen Schichtdicke und den spezifischen Materialeigenschaften als starre Platten oder biegsame Folien ausgestaltet sein.

Hinsichtlich der technologischen Handhabbarkeit und des Wirkungsgrads haben sich Dünnschichtsolarzellen mit einer Halbleiterschicht aus amorphem, mikromorphem oder polykristallinem Silizium, Cadmium-Tellurid (CdTe), GalliumArsenid (GaAs) oder einer Chalkopyrit-Verbindung, insbesondere Kupfer-Indium/Gallium-Dischwefel/Diselenid, abgekürzt durch die Formel Cu (In, Ga) (S, Se)₂, als vorteilhaft erwiesen. Insbesondere Kupfer-Indium-Diselenid (CuInSe₂ bzw. CIS) zeichnet sich aufgrund seines an das Spektrum des Sonnenlichts angepassten Bandabstands durch einen besonders hohen Absorptionskoeffizienten aus.

Mit einzelnen Solarzellen können typischer Weise nur Spannungspegel von weniger als 1 Volt erreicht werden. Um eine technisch brauchbare Ausgangsspannung zu erhalten, werden daher eine Vielzahl Solarzellen in einem Solarmodul seriell miteinander verschaltet. Hierbei bieten Dünnschichtsolarmodule den besonderen Vorteil, dass die Solarzellen schon während der Schichtenherstellung in integrierter Form verschaltet werden können. In der Patentliteratur wurden Dünnschichtsolarmodule bereits mehrfach beschrieben. Lediglich beispielhaft sei auf die Druckschriften DE 4324318 C1 und EP 2200097 A1 verwiesen.

In der Praxis werden Solarmodule auf die Dächer von Gebäuden montiert (Aufdach-Montage) oder bilden einen Teil der Dachhaut (Indach-Montage). Bekannt ist es auch, Solarmodule als Fassaden- oder Wandelemente einzusetzen, insbesondere in Form freiaufgestellter oder freitragender (trägerloser) Glaskonstruktionen.

Die Dachmontage von Solarmodulen erfolgt in der Regel dachparallel an einer am Dach oder einer Dachunterkonstruktion verankerten Modulhalterung. Eine solche Modulhalterung umfasst gewöhnlich ein Schienensystem aus parallelen Tragschienen, beispielsweise Aluminiumschienen, die durch Stahlanker auf Ziegeldächern oder Schrauben auf Wellplatten- oder Trapezblechdächern befestigt sind.

Es ist gängige Praxis, das Solarmodul mit einem aus Aluminium gefertigten Modulrahmen zu versehen, welcher einerseits eine mechanische Verstärkung bewirkt und andererseits für eine Montage des Solarmoduls an der Modulhalterung dienen kann.

In jüngerer Zeit werden zunehmend rahmenlose Solarmodule hergestellt, welche ein verringertes Modulgewicht haben und mit verminderten Fertigungskosten gefertigt werden können. In der Regel werden rahmenlose Solarmodule auf ihrer Rückseite mit Verstärkungsstreben aus Stahl oder Aluminium versehen, welche auf die Modulrückseite aufgeklebt werden. Wie der Modulrahmen wirken die Verstärkungsstreben mechanisch verstärkend und können für eine Befestigung des Solarmoduls an der Modulhalterung dienen. In der Fachwelt werden solche Verstärkungsstreben häufig als "Backrails" bezeichnet. In der Patentliteratur sind Backrails beispielsweise in den Druckschriften DE 102009057937 A1 und US 2009/020 5703 A1 beschrieben. Das deutsche Gebrauchsmuster DE 202010003295 U1 zeigt einen an einem Solarmodul angeklebten Modulträger, wobei in die Klebmasse Abstandshalter eingebracht werden. Derartige Abstandshalter sind auch aus der deutschen Patentanmeldung DE 10 2009 057937 A1 bekannt.

Demgegenüber besteht die Aufgabe der vorliegenden Erfindung darin, die Herstellung rahmenloser Solarmodule mit Verstärkungsstreben (Backrails) in vorteilhafter Weise weiterzubilden, wobei die Solarmodule eine besonders hohe Qualität hinsichtlich der Befestigung der Verstärkungsstreben haben sollen. Zudem sollen die Herstellung vereinfacht und die Montagekosten verringert werden. Diese und weitere Aufgaben werden nach dem Vorschlag der Erfindung durch ein Solarmodul sowie ein Verfahren zur Herstellung eines rahmenlosen Solarmoduls mit den Merkmalen der nebengeordneten Patentansprüche gelöst. Vorteilhafte Ausgestaltungen der Erfindung sind durch die Merkmale der Unteransprüche angegeben.

Erfindungsgemäß ist ein rahmenloses Solarmodul gezeigt, welches ein Substrat und eine Deckschicht aufweist, zwischen denen sich ein Schichtenaufbau zur Formung von Solarzellen befindet. Das Substrat und die Deckschicht bestehen beispielsweise aus anorganischem Glas, Polymeren oder Metalllegierungen und sind beispielsweise als starre Platten ausgestaltet, die in einer so genannten Verbundscheibenstruktur miteinander verbunden sind.

Bei dem rahmenlosen Solarmodul handelt es sich vorzugsweise um ein Dünnschichtsolarmodul mit vorzugsweise in integrierter Form seriell verschalteten Dünnschichtsolarzellen. Typischer Weise umfasst der Schichtenaufbau eine Rückelektrodenschicht, eine Frontelektrodenschicht sowie einen Absorber. Vorzugsweise umfasst der Absorber eine Halbleiterschicht aus einer Chalkopyrit-Verbindung, bei der es sich beispielsweise um einen I-III-VI-Halbleiter aus der Gruppe Kupfer-Indium/Gallium-Dischwefel/Diselenid (Cu(In,Ga) (S,Se)₂), beispielsweise Kupfer-Indium-Diselenid (CuInSe₂ bzw. CIS) oder verwandte Verbindungen, handeln kann.

Auf der dem Schichtenaufbau abgewandten, rückseitigen Substratfläche ist wenigstens ein Modulträger zur Versteifung und/oder tragenden Montage des Solarmoduls an einer ortsfest verankerten Modulhalterung (z.B. Schienensystem) durch Verklebung befestigt. Bei dem Modulträger handelt es sich vorzugsweise um eine Verstärkungsstrebe, die sich entlang den Längsseiten eines in Aufsicht rechteckförmigen Solarmoduls erstreckt. In der Regel ist der Modulträger aus einem anderen Material als das beispielsweise gläserne (Träger-)Substrat gefertigt, wobei er typischer Weise aus einem metallischen Material, beispielsweise Aluminium oder Stahl, besteht. Zur Befestigung am Substrat weist der Modulträger wenigstens eine Klebfläche auf, die durch eine Klebschicht aus einem ausgehärteten Klebstoff mit der rückseitigen Substratfläche verklebt ist.

Wesentlich hierbei ist, dass die Klebschicht ein oder mehrere Abstandshalter enthält, die jeweils dazu ausgebildet sind, die Klebfläche des Modulträgers bei (noch) nicht ausgehärtetem Klebstoff in einem vorgebbaren Mindestabstand zur rückseitigen Substratfläche zu halten, wenn der Modulträger zur rückseitigen Substratfläche zugestellt wird, um den Modulträger durch die Klebschicht mit der rückseitigen Substratfläche zu verbinden.

Das erfindungsgemäße Solarmodul ermöglicht somit in besonders vorteilhafter Weise eine technisch wenig aufwändige, vielfältig variierbare und kostengünstige Befestigung wenigstens eines Modulträgers an der rückseitigen Substratfläche, wobei ein durch die Abstandshalter vorgebbarer Mindestabstand zwischen der Klebfläche des Modulträgers und der rückseitigen Substratfläche zuverlässig und sicher eingehalten werden kann.

In der Praxis sind Solarmodule häufig starken Temperaturschwankungen ausgesetzt, die beispielsweise von -30°C bis +60°C reichen können. Aufgrund der üblicherweise verschiedenen Materialien von Modulträger und Substrat gehen diese Temperaturschwankungen mit unterschiedlichen Wärmeausdehnungen dieser Materialien einher. Dies gilt insbesondere dann, wenn der Modulträger aus einem Metall wie Aluminium oder Stahl und das Substrat aus Glas besteht. In der Folge können starke mechanische Spannungen in den Verklebungen auftreten wenn der Modulträger so nahe an der rückseitigen Substratfläche angeordnet ist, dass durch Wärmeausdehnung ein Berührungskontakt oder zumindest eine Kraftübertragung zwischen Modulträger und Substratfläche auftritt.

Es hat sich gezeigt, dass das Ankleben von Modulträgern am Substrat durch aushärtende Klebstoffe in der industriellen Serienfertigung stets mit einer gewissen Variabilität bezüglich des Abstands zwischen Modulträger und rückseitiger Substratfläche verbunden ist. Ursache hierfür ist die plastische Verformbarkeit des (noch) nicht ausgehärteten Klebstoffs beim Verbinden von Modulträger und Substrat. Bislang war es in der industriellen Serienfertigung von Solarmodulen schwierig einen Mindestabstand zwischen Modulträgern und Substrat zuverlässig und sicher einzuhalten.

Erfindungsgemäß kann durch die Abstandshalter in der wenigstens einen Klebschicht stets gewährleistet werden, dass ein vorgebbarer Mindestabstand zwischen der wenigstens einen Klebfläche des wenigstens einen Modulträgers und der rückseitigen Substratfläche auch bei noch nicht ausgehärtetem Klebstoff eingehalten wird. Die Abstandshalter haben zu diesem Zweck eine Härte, die größer ist als jene des nicht ausgehärteten Klebstoffs. Bei ausgehärtetem Klebstoff ist der Abstand zwischen Modulträger und Substrat auch durch den Klebstoff fixiert. Wird der durch die Abstandshalter vorgebbare Mindestabstand zwischen Modulträger und rückseitiger Substratfläche auf die temperaturbedingten Volumenschwankungen der Materialien von Modulträger und Substrat angepasst, kann sichergestellt werden, dass der am Substrat angeklebte Modulträger von der rückseitigen Substratfläche in einer Weise beabstandet ist, dass bei ausgehärtetem Klebstoff die temperaturbedingten Volumenschwankungen der Materialien durch die Klebschicht aufgenommen werden können. Einem durch die temperaturinduzierten Volumenschwankungen bedingten erhöhten Verschleiß der Verklebungen kann dadurch effektiv entgegen gewirkt werden.

Bei einer Ausgestaltung des erfindungsgemäßen rahmenlosen Solarmoduls ist der wenigstens eine Abstandshalter in der Klebschicht aus einem Material gefertigt, dessen Härte geringer ist als die Härte des Materials des (Träger-)Substrats. Durch diese Maßnahme kann in vorteilhafter Weise erreicht werden, dass lokal erhöhte Belastungen ("Punktbelastungen") des Substrats durch die Abstandshalter vermieden werden, beispielsweise wenn der Modulträger zu dessen Befestigung gegen das Substrat gedrückt wird.

Die Abstandshalter bestehen zu diesem Zweck vorzugsweise aus einem elastisch verformbaren Material, beispielsweise Kunststoff, was eine einfache und kostengünstige Herstellung der Abstandshalter ermöglicht, wobei eine Schädigung des Substrats durch Punktbelastungen zuverlässig und sicher vermieden werden kann.

Vorzugsweise haben die elastisch verformbaren Abstandshalter eine Härte, die zwar größer ist als jene des nicht ausgehärteten Klebstoffs, um den vorgebbaren Mindestabstand zwischen Modulhalter und Substrat bei nicht ausgehärtetem Klebstoff einzuhalten, jedoch maximal der Härte des ausgehärteten Klebstoffs entspricht, so dass bei ausgehärtetem Klebstoff keine Punktbelastungen auftreten. Dies kann für die praktische Anwendung von Solarmodulen wichtig sein, insbesondere dann, wenn hohe Belastungen an den Modulträgern beispielsweise durch Schnee- oder Winddrucklast auftreten. Beispielsweise bestehen die elastisch verformbaren Abstandshalter zu diesem Zweck bei einem gläsernen Substrat aus einem Material, das eine Shore-Härte im Bereich von 60 bis 90 Shore, insbesondere im Bereich von 80 bis 90 Shore, hat.

Die Abstandshalter können grundsätzlich jede für die gewünschte Funktion geeignete Form haben, wobei sie gemäß einer bevorzugten Ausgestaltung der Erfindung jeweils in Kugelform ausgebildet sind, was insbesondere verfahrenstechnische Vorteile mit sich bringt und eine einfache und genaue Einstellung des Mindestabstands durch den Kugeldurchmesser ermöglicht.

Die Abstandshalter können eine zueinander gleiche Abmessung in Richtung des Abstands zwischen Modulträger und rückseitiger Substratfläche haben, beispielsweise einen gleichen Kugeldurchmesser. Erfindungsgemäß haben die Abstandshalter eine voneinander verschiedene Abmessung (bzw. verschiedene) Abmessungen in Richtung des Abstands zwischen Modulträger und rückseitiger Substratfläche zur Einstellung des Mindestabstands zwischen Modulträger und rückseitiger Substratfläche, beispielsweise verschiedene Kugeldurchmesser, wodurch der lokale Mindestabstand zwischen Modulträger und Substrat gezielt auf die speziellen Bedürfnisse von Modulträger und/oder Substrat (z.B. Geometrie des Modulträgers) anpassbar ist. Ist beispielsweise die Geometrie des Modulträgers verschieden, kann durch diese Maßnahme - im Unterschied zu dem Fall einer gleichen Abmessung der Abstandshalter - die Gefahr einer Punktbelastung durch stärker komprimierte Abstandshalter erheblich vermindert werden. Tatsächlich sind elastisch verformbare Abstandshalter (beispielsweise Gummikugeln) in der Regel nur bis zu einem gewissen maximalen Hub komprimierbar. Ist dieser "maximale Hub" erreicht, wirken sie als relativ harte Körper, so dass eine Punktbelastung nicht ausgeschlossen werden kann.

Bei einer weiteren vorteilhaften Ausgestaltung des erfindungsgemäßen Solarmoduls, welches in Rechteckform ausgebildet ist, erstreckt sich der mindestens eine Modulträger beispielsweise in Form einer länglichen Verstärkungsstrebe entlang den (Modul-)Längsseiten und die wenigstens eine Klebschicht ist in Form einer gleichermaßen entlang den (Modul-)Längsseiten sich erstreckenden Klebraupe ausgebildet. Da Solarmodule in Fertigungsstraßen der industriellen Serienfertigung typischer Weise entlang den Längsseiten verfahren werden, kann durch diese Maßnahme in vorteilhafter Weise ein seitliches Versetzen der Abstandshalter (in Modulquerrichtung) vermieden werden. Ein Herausbewegen der Abstandshalter aus der Klebraupe durch Verfahren der Solarmodule kann somit zuverlässig und sicher vermieden werden.

Vorzugsweise umfasst das Solarmodul zwei in Längsrichtung sich erstreckende Modulträger, beispielsweise längliche Verstärkungsstreben, die beiderseits einer zum Substrat senkrechten Längsmittenebene angeordnet sind, wobei die Modulträger jeweils durch mindestens eine in Längsrichtung sich erstreckende Klebraupe mit der rückseitigen Substratfläche verklebt sind, und wobei jede Klebraupe zumindest zwei Abstandshalter enthält, die sich beiderseits einer senkrecht zum Substrat und senkrecht zur Längsmittenebene angeordneten Quermittenebene befinden. Diese Maßnahme ermöglicht eine kostengünstige, zuverlässige und sichere Beabstandung der Modulträger vom Substrat.

Gezeigt, und nicht Teil der Erfindung ist weiterhin ein Verfahren zur Herstellung eines rahmenlosen Solarmoduls, insbesondere Dünnschichtsolarmoduls, welches die folgenden Schritte umfasst:
- Bereitstellen eines Substrats und einer Deckschicht, zwischen denen sich ein Schichtenaufbau zur Formung von Solarzellen befindet,
- Bereitstellen wenigstens eines Modulträgers zur Versteifung und/oder tragenden Montage des Solarmoduls,
- Aufbringen einer Klebschicht aus einem aushärtbaren Klebstoff auf wenigstens einer Klebfläche des Modulträgers und/oder einer vom Schichtenaufbau abgewandten Substratfläche,
- Einbringen von ein oder mehreren Abstandshaltern in den noch nicht ausgehärteten Klebstoff, wobei die Abstandshalter jeweils dazu ausgebildet sind, die Klebfläche bei nicht ausgehärtetem Klebstoff der Klebschicht in einem vorgebbaren Mindestabstand zur Substratfläche zu halten,
- Verbinden des Modulträgers durch die wenigstens eine Klebschicht mit der Substratfläche,
- Aushärten(lassen) des Klebstoffs der Klebschicht zur klebenden Befestigung des Modulträgers am Substrat.

Die Abstandshalter können voneinander verschiedene Abmessungen zum Halten des Abstands zwischen der Klebfläche des Modulträgers und der Substratfläche haben.

Durch das Verfahren kann ein Solarmodul technisch einfach und kostengünstig hergestellt werden, wobei sichergestellt ist, dass die Modulträger von der rückseitigen Substratfläche in einem durch die Abstandshalter vorgebbaren Mindestabstand angeordnet sind.

In verfahrenstechnischer Hinsicht kann es von Vorteil sein, wenn die Abstandshalter in die wenigstens eine, bereits auf der Klebfläche des Modulträgers und/oder der rückseitigen Substratfläche aufgebrachte Klebschicht eingebracht werden. Diese Maßnahme ermöglicht ein einfaches Aufsprühen bzw. Aufspritzen des Klebstoffs aus einer herkömmlichen Düse, wobei die Düse nicht auf die Abmessungen der Abstandshalter anzupassen ist. Es erfolgt das Einbringen der Abstandshalter in die Klebschicht dadurch, dass die Abstandshalter durch einen Druckstoß pneumatisch eingeblasen werden, was technisch in besonders einfacher und kostengünstiger Weise realisierbar ist. Zudem können die Abstandshalter innerhalb der Klebschicht an vorgebbaren Orten gezielt positioniert werden. Des Weiteren können verschieden dimensionierte Abstandshalter in einfacher Weise in die Klebschicht eingebracht werden.

Bei einer weiteren vorteilhaften Ausgestaltung des Verfahrens zur Herstellung eines rahmenlosen rechteckförmigen Solarmoduls erstreckt sich der mindestens eine Modulträger entlang den (Modul-)Längsseiten und die wenigstens eine Klebschicht wird in Form einer entlang den Längsseiten sich erstreckenden Klebraupe ausgebildet, so dass bei der üblichen Verfahrrichtung der Solarmodule ein seitliches Versetzen der Abstandshalter vermieden wird.

Vorzugsweise werden zwei in Längsrichtung sich erstreckende Modulträger beiderseits einer zum Substrat senkrechten Längsmittenebene auf der rückseitigen Substratfläche befestigt, wobei die Modulträger jeweils durch mindestens eine in Längsrichtung sich erstreckende Klebraupe mit der rückseitigen Substratfläche verklebt werden, wobei in die Klebraupe zumindest zwei Abstandshalter eingebracht werden, die sich beiderseits einer senkrecht zum Substrat und senkrecht zur Längsmittenebene angeordneten Quermittenebene befinden.

Das Verfahren kann insbesondere zur Herstellung eines wie oben beschrieben ausgebildeten Solarmoduls der Erfindung dienen.

Des Weiteren erstreckt sich die Erfindung auf die Verwendung wenigstens einer Klebeschicht aus einem aushärtbaren Klebstoff zur Befestigung eines Modulträgers an einer rückseitigen Substratfläche eines rahmenlosen Solarmoduls, insbesondere Dünnschichtsolarmoduls, wobei die Klebschicht ein oder mehrere Abstandshalter enthält, die jeweils dazu ausgebildet sind, den Modulträger bei nicht ausgehärtetem Klebstoff in einem vorgebbaren Mindestabstand zur rückseitigen Substratfläche zu beabstanden, wenn der Modulträger gegen die rückseitige Substratfläche gedrückt wird. Hierbei haben die Abstandshalter voneinander verschiedene Abmessungen zum Halten des Abstands zwischen der Klebfläche des Modulträgers und der Substratfläche.

Die oben genannten Ausgestaltungen des Solarmoduls zur Herstellung eines Solarmoduls können allein oder in beliebigen Kombinationen realisiert sein.

### Kurze Beschreibung der Zeichnungen

Die Erfindung wird nun anhand eines Ausführungsbeispiels näher erläutert, wobei Bezug auf die beigefügten Figuren genommen wird. Es zeigen:
- Fig. 1: anhand einer schematischen (Teil-)Schnittdarstellung die Verklebung einer Verstärkungsstrebe mit der rückseitigen Substratfläche eines Solarmoduls;
- Fig. 2: eine schematische Schnittdarstellung zur Veranschaulichung des Einblasens von Kugeln in die Klebraupe zur Befestigung der Verstärkungsstrebe von Fig. 1;
- Fig. 3A-3B: schematische Perspektivdarstellungen der Verstärkungsstrebe des Solarmoduls von Fig. 1;
- Fig. 4: eine schematische Draufsicht auf die Rückseite des Solarmoduls von Fig. 1;
- Fig. 5: eine schematische Schnittdarstellungen durch das Dünnschichtsolarmoduls von Fig. 1.

### Ausführliche Beschreibung der Zeichnungen

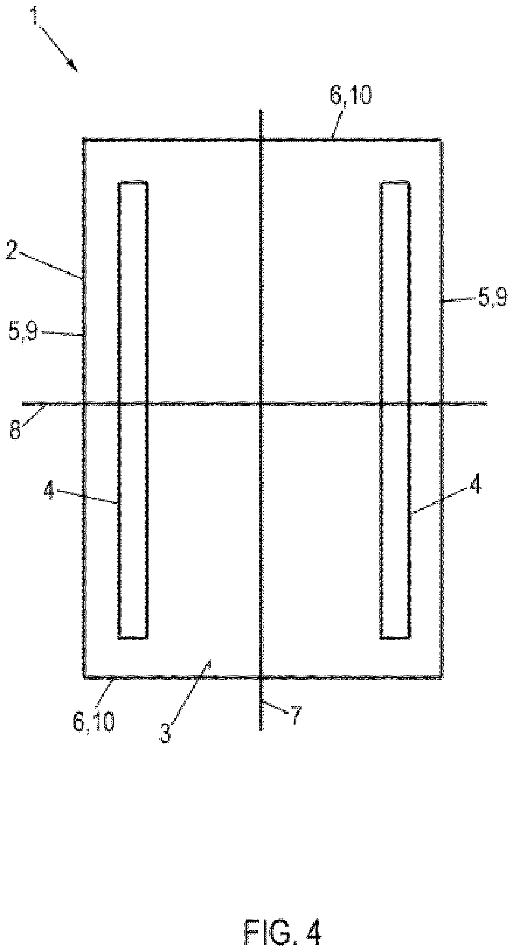

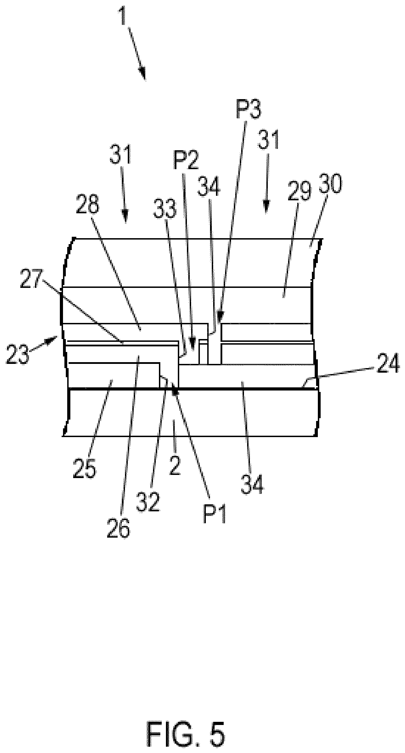

Seien zunächst Fig. 4 und 5 betrachtet. Fig. 4 zeigt eine schematische Ansicht der Modulrückseite ("Seite IV") eines insgesamt mit der Bezugszahl 1 bezeichneten, rahmenlosen Dünnschichtsolarmoduls 1. Wie üblich ist das Solarmodul 1 in Form eines in Aufsicht rechteckförmigen Flächenkörpers mit zwei parallelen Längsseiten 5 und hierzu senkrechten Querseiten 6 ausgebildet. Fig. 5 zeigt eine Schnittdarstellung durch das Dünnschichtsolarmodul 1.

Wie in Fig. 5 erkennbar, hat das Dünnschichtsolarmodul 1 einen der so genannten Substratkonfiguration entsprechenden Aufbau, d.h. es verfügt über ein elektrisch isolierendes (Träger-)Substrat 2 mit einem darauf aufgebrachten Schichtenaufbau 23 aus dünnen Schichten, der auf einer lichteintritts- bzw. vorderseitigen Substratfläche 24 ("Seite III") des Substrats 2 angeordnet ist. Das Substrat 2 besteht hier beispielsweise aus Glas mit einer relativ geringen Lichtdurchlässigkeit, wobei gleichermaßen andere isolierende Materialien mit genügender Festigkeit, sowie inertem Verhalten gegenüber den durchgeführten Prozessschritten eingesetzt werden können.

Konkret umfasst der Schichtenaufbau 23 eine auf der vorderseitigen Substratfläche 24 angeordnete Rückelektrodenschicht 25, die beispielsweise aus einem lichtundurchlässigen Metall wie Molybdän (Mo) besteht und beispielsweise durch Aufdampfen auf das Substrat 2 aufgebracht werden kann. Die Rückelektrodenschicht 25 hat beispielsweise eine Schichtdicke von ca. 1 µm. Auf der Rückelektrodenschicht 25 ist eine Halbleiterschicht 26 abgeschieden, die einen Halbleiter enthält, dessen Bandabstand vorzugsweise in der Lage ist, einen möglichst großen Anteil des Sonnenlichts zu absorbieren. Die Halbleiterschicht 26 besteht beispielsweise aus einem p-leitenden Chalkopyrithalbleiter, beispielsweise einer Verbindung der Gruppe Cu (In, Ga) (S, Se)₂, insbesondere Natrium (Na)-dotiertes Kupfer-Indium-Diselenid (CInSe₂). Die Halbleiterschicht 26 hat beispielsweise eine Schichtdicke, die im Bereich von 1-5 µm liegt und beispielsweise ca. 2 µm beträgt. Auf der Halbleiterschicht 26 ist eine Pufferschicht 27 abgeschieden, die hier beispielsweise aus einer Einzellage Cadmiumsulfid (CdS) und einer Einzellage intrinsisches Zinkoxid (i-ZnO) besteht, was in den Figuren nicht näher dargestellt ist. Die Pufferschicht 27 hat beispielsweise eine geringere Schichtdicke als die Halbleiterschicht 26. Auf die Pufferschicht 27 ist eine Frontelektrodenschicht 28 beispielsweise durch Aufdampfen aufgebracht. Die Frontelektrodenschicht 28 ist für Strahlung im sichtbaren Spektralbereich transparent ("Fensterschicht"), um eine nur geringe Schwächung des einstrahlenden Sonnenlichts zu gewährleisten. Die transparente Frontelektrodenschicht 28, die verallgemeinernd als TCO-Schicht (TCO = Transparent Conductive Electrode) bezeichnet werden kann, basiert auf einem dotierten Metalloxid, beispielsweise n-leitendes, Aluminium (Al)-dotiertes Zinkoxid (ZnO). Durch die Frontelektrodenschicht 28 wird gemeinsam mit der Pufferschicht 27 und der Halbleiterschicht 26 ein Heteroübergang (d.h. Abfolge von Schichten vom entgegen gesetzten Leitungstyp) gebildet. Die Schichtdicke der Frontelektrodenschicht 28 beträgt beispielsweise ca. 300 nm.

Zum Schutz vor Umwelteinflüssen ist auf der Frontelektrodenschicht 28 eine beispielsweise aus Polyvinylbutyral (PVB) oder Ethylenvinylacetat (EVA) bestehende Kunststoffschicht 29 aufgebracht, die mit einer für Sonnenlicht transparenten Deckplatte 30, die beispielsweise aus extraweißem Glas mit geringem Eisengehalt besteht, verklebt ist.

Um die Gesamtmodulspannung zu erhöhen, ist die Modulfläche des Dünnschichtsolarmoduls 1 in eine Vielzahl einzelner Solarzellen 31 aufgeteilt, die in Serienschaltung miteinander verbunden sind. Zu diesem Zweck wird der Schichtenaufbau 23 unter Einsatz einer geeigneten Strukturierungstechnologie, beispielsweise Laserschreiben oder mechanische Bearbeitung (z.B. Abheben oder Ritzen), strukturiert. Eine solche Strukturierung umfasst für jede Solarzelle 31 typischer Weise drei Strukturierungsschritte, die mit den Akronymen P1, P2, P3 abgekürzt werden. In einem ersten Strukturierungsschritt P1 wird die Rückelektrodenschicht 25 durch Erzeugen eines ersten Grabens 32 unterbrochen, was vor dem Aufbringen der Halbleiterschicht 26 erfolgt, so dass der erste Graben 32 durch das Halbleitermaterial dieser Schicht verfüllt wird. In einem zweiten Strukturierungsschritt P2 werden die Halbleiterschicht 26 und die Pufferschicht 27 durch Erzeugen eines zweiten Grabens 33 unterbrochen, was vor dem Aufbringen der Frontelektrodenschicht 28 erfolgt, so dass der zweite Graben 33 durch das elektrisch leitende Material dieser Schicht verfüllt wird. In einem dritten Strukturierungsschritt P3 werden die Frontelektrodenschicht 28, die Pufferschicht 27 und die Halbleiterschicht 26 durch Erzeugen eines dritten Grabens 34 unterbrochen, was vor dem Aufbringen der Kunststoffschicht 29 erfolgt, so dass der dritte Graben 34 durch das isolierende Material dieser Schicht verfüllt wird. Alternativ wäre denkbar, dass der dritte Graben 34 bis zum Substrat 2 hinunter reicht. Durch die beschriebenen Strukturierungsschritte P1, P2, P3 werden seriell miteinander verschaltete Solarzellen 31 gebildet.

Wie in Fig. 4 erkennbar, sind auf der Modulrückseite bzw. rückseitigen Substratfläche 3 des Substrats 2, welche vom Schichtenaufbau zur Formung der Solarzellen abgewandt ist, zwei längliche Verstärkungsstreben 4 (in der Beschreibungseinleitung als "Modulträger" bezeichnet) befestigt. Die Verstärkungsstreben 4 erstrecken sich jeweils entlang den Längsseiten 5 des Solarmoduls 1 und sind beiderseits einer Längsmittenebene 7 des Solarmoduls 1 nahe dem Modullängsrand 9 angeordnet und enden jeweils kurz vor dem Modulquerrand 10.

Durch die beiden länglichen Verstärkungsstreben 4 kann eine mechanische Verstärkung des Solarmoduls 1 erreicht werden. Andererseits dienen die Verstärkungsstreben 4 für eine Montage des Solarmoduls 1 durch Befestigen an einer ortsfest, beispielsweise am Dach oder einer Dachunterkonstruktion, verankerten Modulhalterung, welche typischer eine Mehrzahl beispielsweise aus Aluminium bestehende Tragschienen umfasst. Die beiden Verstärkungsstreben 4 bestehen aus einem metallischen Material, beispielsweise Aluminium oder Stahl. Obgleich in Fig. 4 zwei Verstärkungsstreben 4 gezeigt sind, versteht es sich, dass das Solarmodul 1 gleichermaßen über eine größere oder kleinere Anzahl Verstärkungsstreben 4 verfügen kann.

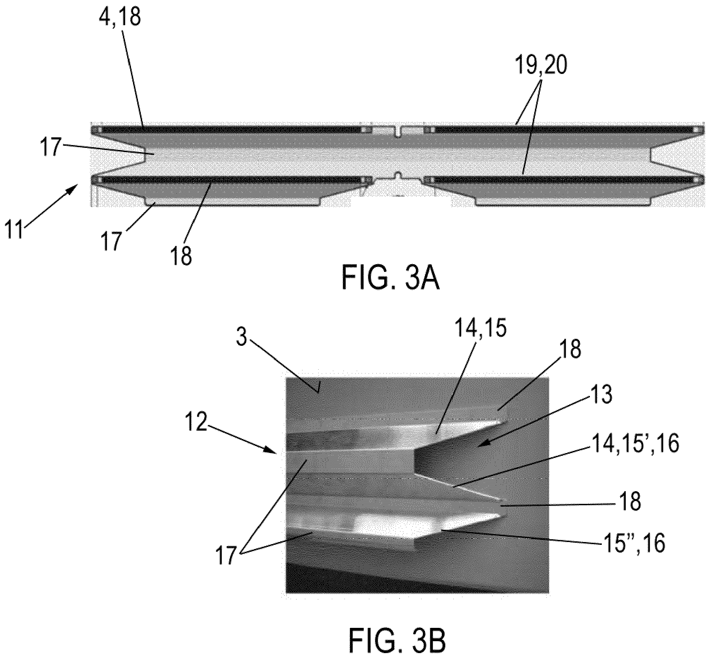

In den Figuren 3A und 3B ist eine einzelne Verstärkungsstrebe 4 näher dargestellt, wobei Fig. 3A eine perspektivische Draufsicht auf die mit der rückseitigen Substratfläche 3 zu verbindenden Vorderseite 11 der Verstärkungsstrebe 4 und Fig. 3B eine perspektivische Ansicht von Stirnseite 13 und Rückseite 12 der Verstärkungsstrebe 4 zeigt.

Demnach ist die Verstärkungsstrebe 4 als Profilteil ausgebildet und beispielsweise durch ein Metallumformverfahren aus einer Metallplatte hergestellt. Die Verstärkungsstrebe 4 kann zumindest gedanklich in zwei im Profil V-förmige Abschnitte 14, 16 zerlegt werden. So umfasst die Verstärkungsstrebe 4 einen ersten V-förmigen Abschnitt 14 mit zwei im spitzen Winkel zueinander angestellten Schenkeln 15, 15' die durch eine rückseitige Leiste 17 miteinander verbunden sind. Die beiden Schenkel 15, 15' sind jeweils mit einer entlang der Längsseiten 5 sich erstreckenden, vorderseitigen Leiste 18 verbunden, die seitlich vom jeweiligen Schenkel 15, 15' abgebogen ist. Die beiden vorderseitigen Leisten 18 stellen Klebflächen 19 zur Befestigung der Verstärkungsstrebe 4 am Substrat 2 bereit. Eine der beiden vorderseitigen Leisten 18 ist mit einem weiteren Schenkel 15'' verbunden, welcher im spitzen Winkel zum benachbarten Schenkel 15' angestellt ist, wodurch gemeinsam mit dem benachbarten Schenkel 15' ein zweiter V-förmiger Abschnitt 16, welcher umgekehrt zum ersten V-förmigen Abschnitt 14 orientiert ist, gebildet wird. An diesem Schenkel 15'' befindet sich eine weitere rückseitige Leiste 17. Durch die im Profil winkelige Struktur der Verstärkungsstrebe 4 kann das Solarmodul 1 sehr effektiv versteift werden.

Wie in Fig. 3A und 3B veranschaulicht, ist auf die beiden Klebflächen 19 der Verstärkungsstrebe 4 jeweils eine Klebraupe 20 aufgebracht, welche zur Verklebung der Verstärkungsstrebe 4 mit der rückseitigen Substratfläche 3 dient. Die Klebraupen 20 erstrecken sich im Wesentlichen über die komplette Länge der Klebflächen 19. Die Klebraupen 20 bestehen aus einem aushärtbaren bzw. im verklebten Zustand ausgehärteten Klebstoff, welcher beispielsweise in Gegenwart von Sauerstoff aushärtet, z.B. ein Zweikomponentenkleber. Typischer Weise ist der Klebstoff im nicht ausgehärteten Zustand weich bzw. plastisch verformbar und geht durch Aushärten in einen harten, gegebenenfalls in gewissem Maße elastisch verformbaren, Zustand über, in dem die Verstärkungsstrebe 4 mit dem Substrat 2 fest verbunden ist.

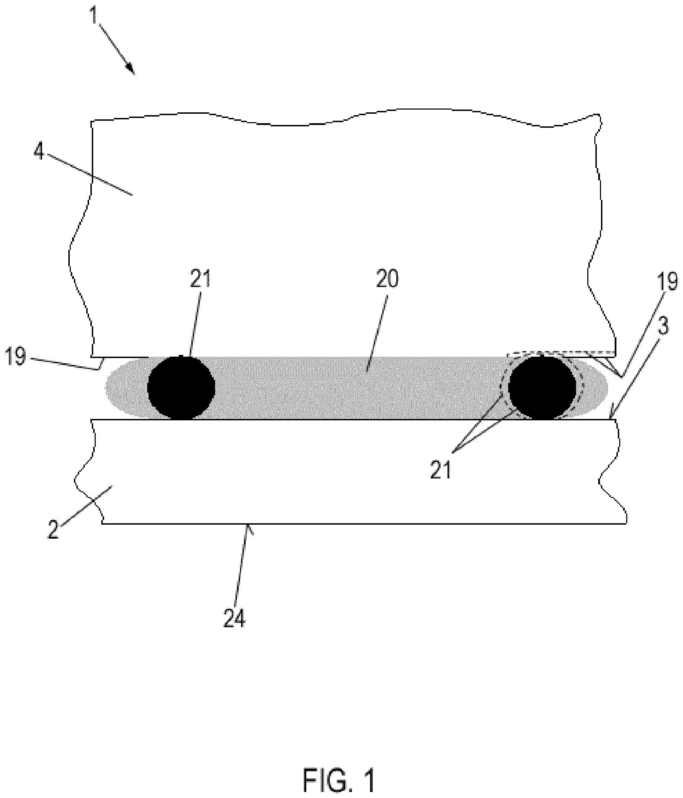

Es wird nun Bezug auf Fig. 1 genommen, worin anhand einer schematischen (Teil-)Schnittdarstellung entlang der Längsseiten 5 des Solarmoduls 1 die Verklebung einer Verstärkungsstrebe 4 mit der rückseitigen Substratfläche 3 des Solarmoduls 1 veranschaulicht ist. Der Schnitt ist durch eine Klebraupe 20 hindurch gelegt.

Demnach befinden sich in der Klebraupe 20 zwei Abstandshalter 21, die hier beispielsweise in Kugelform ausgebildet sind. Durch den beispielsweise gleichen Durchmesser der Abstandshalter 21 kann ein gleicher Mindestabstand zwischen den beiden Klebflächen 19 der Verstärkungsstrebe 4 und der rückseitigen Substratfläche 3 vorgegeben werden, wenn die Verstärkungsstrebe 4 zu deren Verklebung gegen das Substrat 2 gedrückt wird. Wie in Fig. 1 am rechten Abstandshalter 21 angedeutet, können die Abstandshalter 21 auch einen unterschiedlichen Kugeldurchmesser haben, welche den lokalen geometrischen Gegebenheiten von Substrat 2 und/oder Verstärkungsstrebe 4 angepasst sind. Beispielsweise kann der rechte Abstandshalter 21 (gestrichelt in Fig. 1) einen größeren Kugeldurchmesser haben als der linke Abstandshalter 21, um auf diese Weise einen größeren Abstand zwischen Substrat 2 und Verstärkungsstrebe 4 zu realisieren. Dies kann beispielsweise durch eine gegenüber der rückseitigen Substratfläche 3 rückversetzte Klebfläche 19 (in Fig. 1 gestrichelt) der Verstärkungsstrebe 4 verursacht sein. Eine unterschiedlich starke Kompression von Abstandshaltern 21 mit gleichem Kugeldurchmesser mit der Gefahr einer Punktbelastung kann durch Abstandshalter 21 mit verschiedenem Kugeldurchmesser in vorteilhafter Weise vermieden werden.

Die Abstandshalter 21 bestehen hier beispielsweise aus einem elastisch verformbaren Kunststoff, beispielsweise EPDM (Ethylen-Propylen-Dien-Kautschuk) mit einer Shore-Härte von 85 oder POM (Polyoxymethylen) mit einer Shore-Härte von 80. Somit sind die Abstandshalter 21 härter als der nicht ausgehärtete Klebstoff, um die Abstandshalterfunktion erfüllen zu können, sind jedoch nicht "zu hart", so dass Schädigungen durch lokale Punktbelastungen am gläsernen Substrat 2 vermieden werden können. Generell ist die Härte der Abstandshalter 21 geringer als jene des Substrats 2. Zudem entspricht die Härte der Abstandshalter 21 maximal jener des ausgehärteten Klebstoffs, um Punktbelastungen durch die Abstandshalter 21 bei starken Krafteinwirkungen in der Praxis, beispielsweise durch Schnee- oder Winddrucklast, zu vermeiden.

Wie in Fig. 3A gezeigt, befinden sind die Abstandshalter 21 in jeder Klebraupe 20 beiderseits einer in Fig. 4 gezeigten Quermittenebene 8 nahe dem Modulquerrand 10. Durch die vier Abstandshalter 21 pro Verstärkungsstrebe 4 kann der Mindestabstand zwischen Verstärkungsstrebe 4 und Substrat 2 zuverlässig und sicher eingehalten werden. Der Begriff "Mindestabstand" gibt an, dass der Abstand zwischen Verstärkungsstrebe 4 und Substrat 2 durchaus größer sein kann, jedoch wenigstens dem durch die Abstandshalter 21 vorgegeben Abstand entspricht.

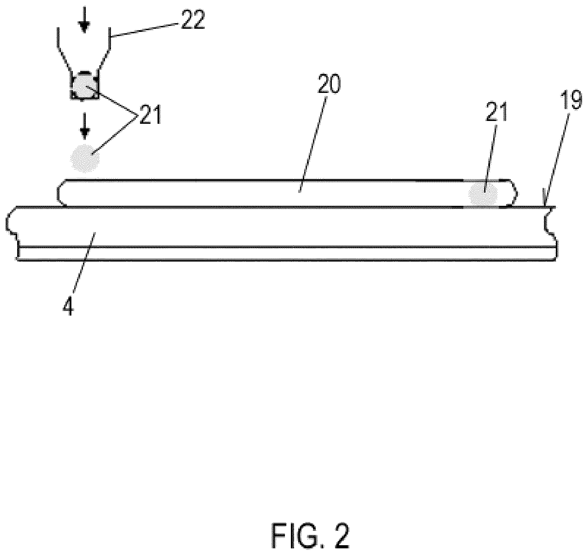

In Fig. 2 ist das Einbringen der Abstandshalter 21 in die jeweilige Klebraupe 20 veranschaulicht. Hierbei wird zunächst die Klebraupe 20 auf jede der beiden Klebflächen 19 der Verstärkungsstrebe 4 aufgebracht. Dies geschieht hier beispielsweise durch Auspressen des noch nicht ausgehärteten Klebstoffs durch eine Klebstoffdüse (nicht gezeigt) mittels Druckbeaufschlagung. Anschließend werden die kugelförmigen Abstandshalter 21 durch eine Abstandshalterdüse 22 in die noch nicht ausgehärtete Klebraupe 20 pneumatisch, d.h. durch Luftstoß, eingeblasen. Dies hat den Vorteil, dass die Klebstoffdüse nicht auf die Abmessungen der Abstandshalter 21 anzupassen ist. Die Abstandshalterdüse 20 kann beispielsweise aus einem zentralen Lager (nicht gezeigt) mit Abstandshaltern 21 gespeist werden, so dass eine einfache Beschickung der Abstandshalterdüse 20 sowie Befüllung des zentralen Lagers ermöglicht ist. Die Abstandshalterdüse 22 kann in der Fertigung beispielsweise neben der Klebstoffdüse angeordnet werden. Die Klebraupe 20 und die Abstandshalterdüse 20 sind relativ zueinander bewegbar, so dass die Abstandshalter 21 gezielt innerhalb der Klebraupe 20 positioniert werden können. Es versteht sich, dass die Abstandhalter 21 anstatt durch pneumatische Druckbeaufschlagung gleichermaßen in anderer Weise in Bewegung versetzt werden können.

Anschließend wird die auf diese Weise vorbehandelte Verstärkungsstrebe 4 mit noch nicht ausgehärtetem Klebstoff gegen die rückseitige Substratfläche 3 gedrückt und solange angedrückt bis der Klebstoff ausgehärtet ist. Hierbei wird durch die Abstandshalter 21 ein durch deren Durchmesser vorgegebener Mindestabstand zwischen Verstärkungsstrebe 4 und Substrat 2 eingehalten. Da das Solarmodul 1 in der industriellen Serienfertigung entlang der Längsseiten 5 verfahren wird, werden die Abstandhalter 21 beim Transport des Solarmoduls 1 nicht aus den Klebraupen 20 heraus versetzt. Die beiden Verstärkungsstreben 4 können somit mit einem Mindestabstand zur Substratfläche 3 auf das Substrat 2 geklebt werden.

Wie sich aus vorstehender Beschreibung ergibt, stellt die Erfindung ein rahmenloses Solarmodul zur Verfügung, das eine einfache, zuverlässige und kostengünstige Verklebung von Modulträgern zur tragenden Befestigung an einer Modulhalterung ermöglicht. Die Modulträger können mit einem vorgebbaren Mindestabstand zur rückseitigen Substratfläche angeklebt werden, zu welchem Zweck Abstands- bzw. Distanzhalter (Spacer) in den noch nicht ausgehärteten Klebstoff einbracht werden.

Weitere Merkmale der Erfindung ergeben sich aus der nachfolgenden Beschreibung:
Ein rahmenloses Solarmodul mit einem Substrat und einer Deckschicht, zwischen denen sich ein Schichtenaufbau zur Formung von Solarzellen befindet, wobei auf einer vom Schichtenaufbau abgewandten Substratfläche wenigstens ein Modulträger zur Versteifung und/oder tragenden Montage des Solarmoduls befestigt ist, der wenigstens eine Klebfläche aufweist, die durch eine Klebschicht aus einem ausgehärteten Klebstoff mit der Substratfläche verklebt ist, wobei die Klebschicht ein oder mehrere Abstandshalter enthält, die jeweils dazu ausgebildet sind, die Klebfläche bei nicht ausgehärtetem Klebstoff der Klebschicht in einem vorgebbaren Mindestabstand zur Substratfläche zu halten.

Bei einer Ausgestaltung haben die Abstandshalter eine Härte, die geringer ist als die Härte des Substrats. Bei einer Ausgestaltung bestehen die Abstandshalter aus einem elastisch verformbaren Material. Bei einer Ausgestaltung haben die Abstandshalter eine Härte, die größer ist als jene des nicht ausgehärteten Klebstoffs der Klebschicht und maximal jener des ausgehärteten Klebstoffs der Klebschicht entspricht. Bei einer Ausgestaltung mit einem gläsernen Substrat hat das elastisch verformbare Material der Abstandshalter eine Shore-Härte im Bereich von 60 bis 90 Shore, insbesondere 80 bis 90 Shore. Bei einer Ausgestaltung sind die Abstandshalter jeweils in Kugelform ausgebildet. Bei einer Ausgestaltung haben die Abstandshalter voneinander verschiedene Abmessungen zum Halten des Abstands zwischen der Klebfläche des Modulträgers und der Substratfläche. Bei einer Ausgestaltung mit einer Rechteckform erstreckt sich der mindestens eine Modulträger entlang der Längsseiten und die wenigstens eine Klebschicht ist in Form einer entlang der Längsseiten sich erstreckenden Klebraupe ausgebildet. Bei einer Ausgestaltung sind zwei entlang der Längsseiten sich erstreckende Modulträger beiderseits einer zum Substrat senkrechten Längsmittenebene auf der Substratfläche befestigt, wobei die Modulträger jeweils durch mindestens eine entlang der Längsseiten sich erstreckende Klebraupe mit der Substratfläche verklebt sind, wobei die Klebraupe zumindest zwei Abstandshalter enthält, die sich beiderseits einer senkrecht zum Substrat und senkrecht zur Längsmittenebene angeordneten Quermittenebene befinden.

### Bezugszeichenliste

- 1: Dünnschichtsolarmodul
- 2: Substrat
- 3: rückseitige Substratfläche
- 4: Verstärkungsstrebe
- 5: Längsseite
- 6: Querseite
- 7: Längsmittenebene
- 8: Quermittenebene
- 9: Modullängsrand
- 10: Modulquerrand
- 11: Vorderseite
- 12: Rückseite
- 13: Stirnseite
- 14: erster V-förmiger Abschnitt
- 15, 15', 15'': Schenkel
- 16: zweiter V-förmiger Abschnitt
- 17: rückseitige Leiste
- 18: vorderseitige Leiste
- 19: Klebfläche
- 20: Klebraupe
- 21: Abstandshalter
- 22: Abstandshalterdüse
- 23: Schichtenaufbau
- 24: vorderseitige Substratfläche
- 25: Rückelektrodenschicht
- 26: Halbleiterschicht
- 27: Pufferschicht
- 28: Frontelektrodenschicht
- 29: Kunststoffschicht
- 30: Deckplatte
- 31: Solarzelle
- 32: erster Graben
- 33: zweiter Graben
- 34: dritter Graben

## Patentansprüche

1. Rahmenloses Solarmodul (1) mit einem Substrat (2) und einer Deckschicht (30), zwischen denen sich ein Schichtenaufbau (23) zur Formung von Solarzellen (31) befindet, wobei auf einer vom Schichtenaufbau (23) abgewandten Substratfläche (3) wenigstens ein Modulträger (4) zur Versteifung und/oder tragenden Montage des Solarmoduls (1) befestigt ist, der wenigstens eine Klebfläche (19) aufweist, die durch eine Klebschicht (20) aus einem ausgehärteten Klebstoff mit der Substratfläche (3) verklebt ist, wobei die Klebschicht (19) ein oder mehrere Abstandshalter (21) enthält, die jeweils dazu ausgebildet sind, die Klebfläche (19) bei nicht ausgehärtetem Klebstoff der Klebschicht (20) in einem vorgebbaren Mindestabstand zur Substratfläche (3) zu halten,
**dadurch gekennzeichnet, dass**
die Abstandshalter (21) voneinander verschiedene Abmessungen zum Halten des Abstands zwischen der Klebfläche (19) des Modulträgers (4) und der Substratfläche (3) haben.

2. Rahmenloses Solarmodul (1) nach Anspruch 1, bei welchem die Abstandshalter (21) eine Härte haben, die geringer ist als die Härte des Substrats (2).

3. Rahmenloses Solarmodul (1) nach Anspruch 2, bei welchem die Abstandshalter (21) aus einem elastisch verformbaren Material bestehen.

4. Rahmenloses Solarmodul (1) nach Anspruch 3, bei welchem die Abstandshalter (21) eine Härte haben, die größer ist als jene des nicht ausgehärteten Klebstoffs der Klebschicht (20) und maximal jener des ausgehärteten Klebstoffs der Klebschicht (20) entspricht.

5. Rahmenloses Solarmodul (1) mit einem gläsernen Substrat (2) nach Anspruch 4, bei welchem das elastisch verformbare Material der Abstandshalter (21) eine Shore-Härte im Bereich von 60 bis 90 Shore, insbesondere 80 bis 90 Shore, hat.

6. Rahmenloses Solarmodul (1) nach einem der Ansprüche 1 bis 5, bei welchem die Abstandshalter (21) jeweils in Kugelform ausgebildet sind.

7. Rahmenloses Solarmodul (1) mit einer Rechteckform nach einem der Ansprüche 1 bis 6, bei welchem sich der mindestens eine Modulträger (4) entlang der Längsseiten (5) erstreckt und die wenigstens eine Klebschicht (20) in Form einer entlang der Längsseiten (5) sich erstreckenden Klebraupe (20) ausgebildet ist.

8. Rahmenloses Solarmodul (1) nach Anspruch 7, bei welchem zwei entlang der Längsseiten (5) sich erstreckende Modulträger (4) beiderseits einer zum Substrat (2) senkrechten Längsmittenebene (7) auf der Substratfläche (3) befestigt sind, wobei die Modulträger (4) jeweils durch mindestens eine entlang der Längsseiten (5) sich erstreckende Klebraupe (20) mit der Substratfläche (3) verklebt ist, wobei die Klebraupe (20) zumindest zwei Abstandshalter (21) enthält, die sich beiderseits einer senkrecht zum Substrat (2) und senkrecht zur Längsmittenebene (7) angeordneten Quermittenebene (8) befinden.

9. Verwendung wenigstens einer Klebschicht (20) aus einem aushärtbaren Klebstoff zur Befestigung eines Modulträgers (4) an einer Substratfläche (3) eines rahmenlosen Solarmoduls (1), wobei die Klebschicht (20) ein oder mehrere Abstandshalter (21) enthält, die jeweils dazu ausgebildet sind, den Modulträger (4) bei nicht ausgehärtetem Klebstoff in einem vorgebbaren Mindestabstand zur Substratfläche (3) zu halten,
**dadurch gekennzeichnet, dass**
die Abstandshalter (21) voneinander verschiedene Abmessungen zum Halten des Abstands zwischen der Klebfläche (19) des Modulträgers (4) und der Substratfläche (3) haben.

## Claims

1. Frameless solar module (1) having a substrate (2) and a cover layer (30), between which a layer structure (23) for forming solar cells (31) is situated, wherein at least one module carrier (4) for reinforcing and/or supporting mounting of the solar module (1) is fastened on a substrate surface (3) facing away from the layer structure (23), which module carrier (4) has at least one adhesive surface (19) which is adhesively bonded to the substrate surface (3) by an adhesive layer (20) made of a cured adhesive, wherein the adhesive layer (20) includes one or a plurality of spacers (21), which are in each case implemented to maintain the adhesive surface (19) at a pre-specifiable minimum distance from the substrate surface (3) when the adhesive of the adhesive layer (20) is not cured, **characterized in that** the spacers (21) have mutually different dimensions for maintaining the distance between the adhesive surface (19) of the module carrier (4) and the substrate surface (3).

2. Frameless solar module (1) according to claim 1, wherein the spacers (21) have a hardness that is less than the hardness of the substrate (2).

3. Frameless solar module (1) according to claim 2, wherein the spacers (21) are made of an elastically malleable material.

4. Frameless solar module (1) according to claim 3, wherein the spacers (21) have a hardness that is greater than that of the not cured adhesive of the adhesive layer (20) and corresponds at a maximum to that of the cured adhesive of the adhesive layer (20).

5. Frameless solar module (1) with a glass substrate (2) according to claim 4, wherein the elastically malleable material of the spacers (21) has a Shore hardness in the range from 60 to 90 Shore, in particular 80 to 90 Shore.

6. Frameless solar module (1) according to one of claims 1 through 5, wherein the spacers (21) are implemented in each case with a spherical shape.

7. Frameless solar module (1) with a rectangular shape according to one of claims 1 through 6, wherein the at least one module carrier (4) extends along the longitudinal sides (5) and the at least one adhesive layer (20) is implemented in the form of an adhesive bead (20) extending along the longitudinal sides (5).

8. Frameless solar module (1) according to claim 7, wherein two module carriers (4) extending along the longitudinal sides (5) are fastened on the substrate surface (3) on both sides of a longitudinal median plane (7) perpendicular to the substrate (2), wherein the module carriers (4) are in each case adhesively bonded to the substrate surface (3) by at least one adhesive bead (20) extending along the longitudinal sides (5), wherein the adhesive bead (20) contains at least two spacers (21) that are situated on both sides of a transverse median plane (8) arranged perpendicular to the substrate (2) and perpendicular to the longitudinal median plane (7).

9. Use of at least one adhesive layer (20) made of a curable adhesive for fastening a module carrier (4) on a substrate surface (3) of a frameless solar module (1), wherein the adhesive layer (20) contains one or a plurality of spacers (21), which are in each case implemented to maintain the module carrier (4) at a pre-specifiable minimum distance from the substrate surface (3) when the adhesive is not cured, **characterized in that** the spacers (21) have mutually different dimensions for maintaining the distance between the adhesive surface (19) of the module carrier (4) and the substrate surface (3).

## Revendications

1. Module solaire sans cadre (1) avec un substrat (2) et une couche de surface (30), entre lesquels se trouve une structure en couches (23) pour la formation de cellules solaires (31), où au moins un porte-module (4) pour le renforcement et/ou le montage du module solaire (1) est fixé sur une surface du substrat (3) détournée de la structure en couches (23), qui présente au moins une couche adhésive (19), qui est collée à la surface du substrat (3) par une couche adhésive (20) en adhésif durci, où la couche adhésive (19) contient un ou plusieurs écarteurs (21), qui sont formés respectivement pour maintenir la surface à coller (19) à une distance minimum prédéterminée par rapport à la surface du substrat (3) tant que l'adhésif de la couche adhésive (20) n'est pas durci, **caractérisé en ce que** les écarteurs (21) entre eux ont des dimensions différentes pour maintenir la distance entre la surface adhésive (19) du porte-module (4) et la surface du substrat (3).

2. Module solaire sans cadre (1) selon la revendication 1, où les écarteurs (21) présentent une dureté, qui est inférieure à celle du substrat (2).

3. Module solaire sans cadre (1) selon la revendication 2, où les écarteurs (21) sont fabriqués d'un matériau élastiquement déformable.

4. Module solaire sans cadre (1) selon la revendication 3, où les écarteurs (21) présentent une dureté, qui est supérieure à celle de l'adhésif non durci de la couche adhésive (20) et correspond au maximum à celle de l'adhésif durci de la couche adhésive (20).

5. Module solaire sans cadre (1), avec un substrat en verre (2) selon la revendication 4, où le matériau élastiquement déformable des écarteurs (21) présente une dureté Shore de l'ordre de 60 à 90 Shore, en particulier de 80 à 90 Shore.

6. Module solaire sans cadre (1) selon l'une des revendications 1 à 5, où les écarteurs (21) sont formés respectivement sous forme sphérique.

7. Module solaire sans cadre (1) avec une forme rectangulaire selon l'une des revendications 1 à 6, où ledit au moins un porte-module (4) s'étend le long des côtés longitudinaux (5) et ladite au moins une couche adhésive (20) est formée comme une bande adhésive (20) qui s'étend le long des côtés longitudinaux (5).

8. Module solaire (1) sans cadre selon la revendication 7, où deux porte-modules (4) s'étendant le long des côtés longitudinaux (5) des deux côtés d'un plan médian longitudinal (7) perpendiculaire au substrat (2) sont fixés sur la surface du substrat (3,) où les porte-modules (4) sont respectivement collés à la surface du substrat (3) par au moins une bande adhésive (20) le long des côtés longitudinaux (5), où la bande adhésive (20) contient au moins deux écarteurs (21), qui se trouvent respectivement des deux côtés d'un plan transversal médian (8) disposé perpendiculaire au substrat (2) et perpendiculaire au plan médian longitudinal (7).

9. Utilisation d'au moins une couche adhésive (20) d'un adhésif durcissable pour fixer un porte-module (4) sur une surface d'un substrat (3), d'un module solaire sans cadre (1) où la couche adhésive (20) contient un ou plusieurs écarteurs (21), qui sont prévus pour maintenir le porte-module (4) à une distance minimum prédéterminée de la surface du substrat (3) tant que l'adhésif n'est pas durci, **caractérisé en ce que** les écarteurs (21) entre eux ont des dimensions différentes pour maintenir la distance entre la surface adhésive (19) du porte-module (4) et la surface du substrat (3).
